# EUROPEAN PATENT SPECIFICATION

(11) **EP 4 394 891 B1**
(45) Date of publication and mention of the grant of the patent: **29.07.2026**
(21) Application number: 21794701.9
(22) Date of filing: 03.09.2021
(51) Int. Cl.: H10D 30/67, H10D 99/00

(54) **THIN-FILM TRANSISTOR ARRAY SUBSTRATE AND MANUFACTURING METHOD THEREFOR**
DÜNNSCHICHTTRANSISTORARRAYSUBSTRAT UND HERSTELLUNGSVERFAHREN DAFÜR
SUBSTRAT MATRICIEL DE TRANSISTOR À COUCHES MINCES ET SON PROCÉDÉ DE FABRICATION

(30) Priority: 25.08.2021 CN 202110978870
(43) Date of publication of application: 03.07.2024
(73) Proprietor: Shenzhen China Star Optoelectronics Semiconductor Display Technology Co., Ltd., Shenzhen, Guangdong 518132 (CN)
(72) Inventor: ZHUO, Yi, Shenzhen, Guangdong 518132 (CN)
(74) Representative: Patentanwälte Olbricht Buchhold Keulertz
(86) International application number: PCT/CN2021/116346
(87) International publication number: WO 2023/024146

(56) References cited:
- CN-A- 106 129 122
- CN-A- 110 993 651
- CN-A- 111 415 948
- CN-A- 112 534 587
- KR-B1- 101 421 288
- US-A1- 2018 308 984
- US-A1- 2018 358 468
- US-A1- 2019 074 383
- US-A1- 2020 303 428
- US-A1- 2021 057 585

## Description

### BACKGROUND OF INVENTION

### 1. FIELD OF INVENTION

The present invention relates to a technical field of displays, and more particularly to a thin-film transistor array substrate and a method of manufacturing the same.

### 2. RELATED ART

With development of display technologies, flat panel displays have become mainstream displays at present. General flat panel displays include liquid crystal displays (LCDs) and active matrix organic light-emitting diodes (AMOLEDs).

In the flat panel displays, thin-film transistor (TFT) array substrates are main driving elements and necessary structures for high-performance flat panel display devices. The TFT array substrates include a plurality of thin-film transistors arranged in an array. There are different types of thin-film transistors, such as bottom gate thin-film transistors or top gate thin-film transistors. The top gate thin-film transistors have lower parasitic capacitance and better ductility because there is no overlap between source/drain electrodes and gate electrodes, and can reduce delays in signal transmission. In technologies of metal oxide thin-film transistors with top gate structures, in order to reduce resistance occurred outside channels, self-aligned etching processes are often used. That is, gate patterns are formed at a same time when gate insulating layers are etched through one time of photolithography process, which is also used for non-channel portions in electrically conductive formation, so that it can effectively prevent high resistance regions on both sides of the channel from being caused by alignment deviation However, diffusion of conductive effects on both ends of the channel will lead to low-resistance regions at the both ends of the channel. That is, an effective channel length becomes shorter, which is not conducive to downsizing of TFT devices.

US 2021/057585 A1, CN 111415948 A, KR 101421288 B1, and US 2018/308984 A1 are related prior arts for this field.

### SUMMARY OF INVENTION

The subject matter of the present invention is defined in independent claims 1 and 5.

An object of the present application is to provide a thin-film transistor array substrate and a method of manufacturing the same to overcome a technical problem that diffusion of electrically conductive effects on both ends of a channel of a conventional thin-film transistor device will lead to low-resistance regions at the both ends of the channel, resulting in a decrease in an effective channel length, which is not conducive to downsizing of thin-film transistor devices.

To achieve the above-mentioned object, the present application provides a technical solution as follows:
An embodiment of the present application provides a thin-film transistor array substrate, comprising a substrate; a platform layer disposed on the substrate; an oxide active layer disposed on the substrate and located above the platform layer and comprising a channel portion and conductor portions located on opposite sides of the channel portion, wherein a vertical level of a top surface of the channel portion is higher than a vertical level of a top surface of any one of the conductor portions; a gate insulating layer disposed on the oxide active layer; a gate electrode disposed on the gate insulating layer, wherein an orthographic projection of the gate electrode on the substrate covers orthographic projections of the platform layer and the channel portion on the substrate; and a source electrode and a drain electrode both electrically connected to the conductor portions.

Further, the thin-film transistor array substrate further comprises a buffer layer disposed on the substrate and covers the platform layer, wherein the platform layer is made of an insulating material or a metal oxide.

Further, the buffer layer comprises a convex portion, and the channel portion is disposed on the convex portion and covers the entire convex portion.

Further, the channel portion comprises two slopes, and one end of each of the slopes is connected to a corresponding one of the conductor portions, wherein each of the slopes is inclined in a direction away from the channel portion and toward the corresponding conductor portion.

Further, the platform layer comprises a first end surface and a second end surface inclined outward, respectively, and the orthographic projection of the channel portion on the substrate covers the orthographic projection of the platform layer on the substrate.

Further, the gate insulating layer comprises two offset portions disposed opposite to each other, wherein each of the offset portions is defined between a side edge of the gate electrode and a side edge of the gate insulating layer adjacent to the side edge of the gate electrode such that orthographic projections of the two offset portions on the substrate cover orthographic projections of the first end surface and the second end surface of the platform layer and orthographic projections of the slopes of the channel portion on the substrate, respectively.

Further, the thin-film transistor array substrate further comprises an interlayer dielectric layer covering the oxide active layer, the gate insulating layer, and the gate electrode, and comprising a plurality of via holes, wherein the source electrode and the drain electrode are arranged on the interlayer dielectric layer and are electrically connected to the conductor portions through the via holes.

An embodiment of the present application further provides a method of manufacturing a thin-film transistor array substrate, comprising depositing a platform layer on a substrate, wherein the platform layer is made of an insulating material or a metal oxide; forming an oxide active layer on the substrate, and forming a channel portion and conductor regions located on two opposite sides of the channel portion by using a photolithography process; depositing a gate insulating layer on the oxide active layer; depositing a gate metal layer on the gate insulating layer; forming, by using a photolithography process to pattern the gate metal layer, a gate electrode, and etching self-alignedly the gate insulating layer to expose the conductor portions of the oxide active layer, wherein an orthographic projection of the gate electrode on the substrate covers orthographic projections of the platform layer and the channel portion on the substrate; performing a plasma treatment in a full-surface way to make the conductor regions of the oxide active layer conductive to form conductor portions, wherein a vertical level of a top surface of the channel portion is higher than a vertical level of a top surface of any one of the conductor portions; depositing an interlayer dielectric layer to cover the oxide active layer, the gate insulating layer, and the gate electrode, and patterning the interlayer dielectric layer to form a plurality of via holes; and depositing and patterning a source electrode/drain electrode metal layer into a source electrode and a drain electrode, wherein the source electrode and the drain electrode are electrically connected to the conductor portions of the oxide active layer through the via holes.

Further, prior to the step of forming the oxide active layer on the substrate, the method further comprises: depositing a buffer layer on the substrate to cover the platform layer, and the buffer layer is formed by a photolithography process to form a convex portion located directly above the platform layer, wherein the channel portion is disposed on the convex portion and covers the entire convex portion.

Further, the channel portion comprises two slopes, one end of each of the slopes is connected to a corresponding one of the conductor portions, and each of the slopes is inclined in a direction away from the channel portion and toward the corresponding conductor portion, wherein the gate insulating layer comprises two offset portions disposed opposite to each other, wherein each of the offset portions is formed between a side edge of the gate electrode and a side edge of the gate insulating layer adjacent to the side edge of the gate electrode such that orthographic projections of the two offset portions on the substrate cover orthographic projections of the first end surface and the second end surface of the platform layer and orthographic projections of the slopes of the channel portion on the substrate, respectively.

An embodiment of the present application further provides a thin-film transistor array substrate, comprising a substrate; a platform layer disposed on the substrate, wherein the platform layer is made of an insulating material or a metal oxide; an oxide active layer disposed on the substrate and located above the platform layer, and comprising a channel portion and conductor portions located on opposite sides of the channel portion, wherein the channel portion comprises two slopes, one end of each of the slopes is connected to a corresponding one of the conductor portions, and the other end extends from the channel portion, wherein a vertical level of a top surface of the channel portion is higher than a vertical level of a top surface of any one of the conductor portions; a gate insulating layer disposed on the oxide active layer; a gate electrode disposed on the gate insulating layer, wherein an orthographic projection of the gate electrode on the substrate covers orthographic projections of the platform layer and the channel portion on the substrate; and a source electrode and a drain electrode both electrically connected to the conductor portions.

The present application has advantageous effects as follows: embodiments of the present application provide a thin-film transistor array substrate and a method of manufacturing the same. A platform layer and adjustment of angles of a first end surface and a second end surface of the platform layer are used to allow for formation of gentle slope-shaped offset portions of upper film layer structures, such that orthographic projections of the offset portions on a substrate cover orthographic projections of slopes of a channel portion on the substrate, and fall on a first end surface and a second end surface of the platform layer, respectively. With the provision of the offset portions, a conductive diffusion path of the oxide active layer is extended such that lengths of low-resistance regions formed through diffusion from two ends of the channel portion to an inside of the channel portion are reduced after the self-aligned etching process, so as to effectively regulate or suppress shortening of an effective channel length, and ensure the effective channel length, thereby facilitating fulfillment of downsizing of thin-film transistor devices and effectively overcoming a technical problem that diffusion of electrically conductive effects on both ends of a channel of a conventional thin-film transistor device will lead to low-resistance regions at the both ends of the channel, resulting in a decrease in an effective channel length, which is not conducive to downsizing of thin-film transistor devices.

### BRIEF DESCRIPTION OF DRAWINGS

To describe the technical solutions in the embodiments of the present invention, the following briefly introduces the accompanying drawings for describing the embodiments. Apparently, the accompanying drawings in the following description show merely some embodiments of the present invention, and a person skilled in the art may still derive other drawings from these accompanying drawings without creative efforts.
FIG. 1 is a schematic cross-sectional plan view of a thin-film transistor array substrate of an embodiment of the present application.
FIG. 2 is a schematic cross-sectional view of a thin-film transistor array substrate of another embodiment of the present application.
FIG. 3 is a flowchart of a method of manufacturing a thin-film transistor array substrate of an embodiment of the present application.
FIGs. 4 to 11 are schematic views of film layer structures of a thin-film transistor fabricated in each step in the method of manufacturing the thin-film transistor array substrate according to the embodiment of the application.

### DESCRIPTION OF PREFERRED EMBODIMENTS

The following embodiments are referring to the accompanying drawings for exemplifying specific implementable embodiments of the present invention. Directional terms described by the present invention, such as upper, lower, front, back, left, right, inner, outer, side, etc., are only directions by referring to the accompanying drawings, and thus the used directional terms are used to describe and understand the present invention, but the present invention is not limited thereto. In the drawings, units with similar structures are indicated by the same reference numerals. In the drawings, for clear understanding and ease of description, the thickness of some layers and regions are exaggerated. That is, the size and thickness of each component shown in the drawings are arbitrarily shown, but the application is not limited to them.

An embodiment of the present application provides a thin-film transistor, which can be arranged in an array and fabricated into a thin-film transistor array substrate. The thin-film transistor array substrate is provided with a plurality of gate scan lines and a plurality of data lines. The gate scan lines and the data lines collectively define a plurality of pixel units, and each of the pixel units is provided with the thin-film transistor and a pixel electrode. The thin-film transistor array substrate may serve as a driving substrate of a liquid crystal display or an organic light-emitting diode display.

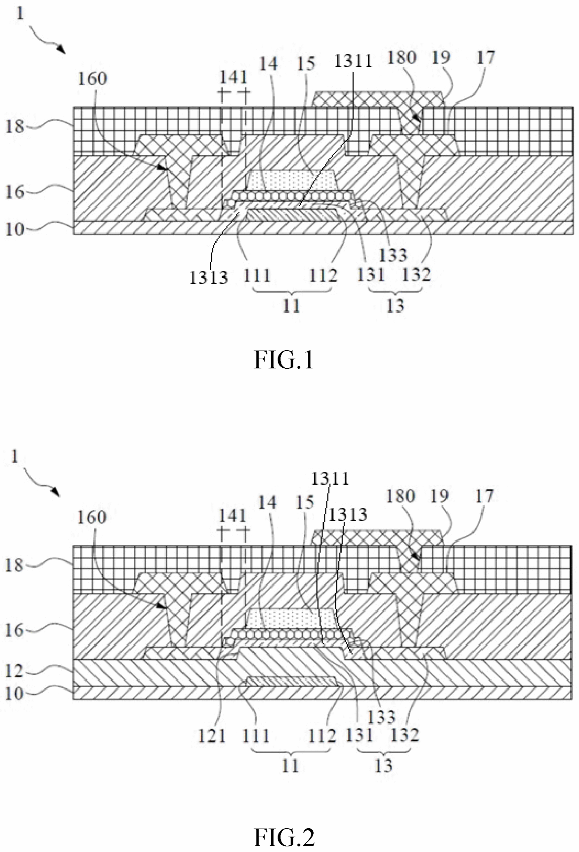

Please refer to FIG. 1, which is a schematic cross-sectional plan view of a thin-film transistor array substrate 1 of an embodiment of the present application. As shown in FIG. 1, the thin-film transistor array substrate 1 provided by the embodiment of the present application includes a substrate 10, a platform layer 11, an oxide active layer 13, a gate insulating layer 14, a gate electrode 15, an interlayer dielectric layer 16, source and drain electrodes 17, a passivation layer 18, and a pixel electrode 19 arranged in sequence. A material of the substrate 10 can be glass or transparent plastic and other materials, preferably glass. The platform layer 11 is disposed on a surface of the substrate 10. Specifically, an insulating material is used to deposit a layer of platform film, which is being patterned through a photolithography process to form the platform layer 11. The platform layer 11 includes a top surface, a first end surface 111, and a second end surface 112. It should be noted that the first end surface 111 and the second end surface 112 are disposed at two opposite ends of the platform layer 11, respectively. Each of the first end surface 111 and the second end surface 112 tilts outward in a direction from the top surface of the platform layer 11 toward the substrate 10. Preferably, the first end surface 111 and the substrate 10 form an angle between 40° and 80°, and the second end surface 112 forms an angle between 40° and 80° with respect to the substrate 10. In one embodiment, the angle between the first end surface 111 and the substrate 10 is the same as the angle between the second end surface 112 and the substrate 10. It should be noted that the above-mentioned angle range is set according to capability ranges of etching processes, and can facilitate oblique formation of upper film layers.

As shown in FIG. 1, the oxide active layer 13 is disposed on the substrate 10. The oxide active layer 13 can be a metal oxide semiconductor made of a material, such as indium gallium zinc oxide (IGZO), indium zinc tin oxide (IZTO) or indium gallium zinc tin oxide (IGZTO). The oxide active layer 13 includes a channel portion 131 and conductor portions 132 located on opposite sides of the channel portion 131, wherein the channel portion 131 is located directly above the platform layer 11. It should be noted that since the platform layer 11 is disposed on the surface of the substrate 10, a height of the channel portion 131 is thus raised, so that the channel portion 131 and the conductor portion 132 are located at different horizontal positions, respectively. That is, a vertical level of a top surface of the channel portion 131 is higher than a vertical level of a top surface of any one of the conductor portions 132. Specifically, the channel portion 131 includes two slopes 133, and one end of each of the slopes 133 is connected to a corresponding one of the conductor portions 132, the other end extends from the channel portion 131. Each of the slopes 133 is inclined in a direction away from the channel portion 131 and toward the corresponding conductor portion 132.

Continuing referring to FIG. 1, the gate insulating layer 14 is disposed on the oxide active layer 13. The gate electrode 15 is disposed on the gate insulating layer 14. It should be noted that the gate electrode 15 is formed by patterning a gate metal layer through a photolithography process, and the gate insulating layer 14 is being etched self-alignedly to expose conductor regions 130 of the oxide active layer 13. Then, a plasma treatment is performed in a way of full-surface to make the conductor regions 130 of the oxide active layer 13 conductive, thereby forming conductor portions 132. Specifically, after the gate insulating layer 14 undergoes the photolithography process and self-aligned etching, two offset portions 141 are formed. The two offset portions 141 are disposed at two opposite ends of the gate insulating layer 14, and each of the offset portions 141 is arranged in conformity with a corresponding one of the slopes 133 of the channel portion 131 and covers the corresponding slope 133. Specifically, each of the offset portions 141 is defined between a side edge of the gate electrode 15 and a side edge of the gate insulating layer 14 adjacent to the side edge of the gate electrode 15. It should be noted that a length of the platform layer 11 is less than a length of the channel portion 131 and is substantially the same as a length of the gate electrode 15. That is, an orthographic projection of the gate electrode 15 on the substrate 10 covers orthographic projections of the platform layer 11 and the channel portion 131 on the substrate 10. In this embodiment, a length difference between the platform layer 11 and the gate electrode 15 is less than two microns. It can be seen from the schematic cross-sectional view of the thin-film transistor array substrate 1 in FIG. 1 that the first end surface 111 and the second end surface 112 of the platform layer 11 each extend beyond a length range of the gate electrode 15 in vertical cross-section. In other words, an orthographic projection of each offset portion 141 on the substrate 10 covers an orthographic projection of the first end surface 111 or an orthographic projection of the second end surface 112 of the platform layer 11 on the substrate 10.

As shown in FIG. 1, an interlayer dielectric layer 16 is deposited on the substrate 10 to cover the oxide active layer 13, the gate insulating layer 14, and the gate electrode 15. The interlayer dielectric layer 16 is patterned to form a plurality of via holes 160. The source electrode and the drain electrode 17 are disposed on the interlayer dielectric layer 16 and are electrically connected to the conductor portions 132 of the oxide active layer 13 through corresponding via holes 160. In addition, a passivation layer 18 is further formed on the interlayer dielectric layer 16 and is made of a material, such as nitride (silicon nitride, etc.) or oxide (silicon oxide, silicon dioxide), or is configured with a multilayer structure film. In another embodiment, a planarization layer (not shown) is further disposed on the passivation layer 18. The planarization layer can provide further protection for underlying film layers and provide a better planarization effect. A pixel electrode 19 is disposed on the passivation layer 18 or on the planarization layer. The pixel electrode 19 is formed through a patterned metal layer and is electrically connected to the source electrode and the drain electrode 17 through a through hole 180. Based on the aforementioned components, the embodiment of the present application provides a top gate thin-film transistor array substrate 1, which can serve as a driving substrate for subsequent liquid crystal displays or organic light-emitting diode displays.

Please refer to FIG. 2, which is a schematic cross-sectional view of the thin-film transistor array substrate 1 in another embodiment of the present application. A difference between the embodiments shown in FIG. 2 and FIG. 1 is that the thin-film transistor array substrate 1 of FIG. 2 is further provided with a buffer layer 12 (details will be described later). Other same components in the aforementioned embodiments will not be described in detail here. As shown in FIG. 2, the thin-film transistor array substrate 1 provided by the embodiment of the application includes a substrate 10, a platform layer 11, a buffer layer 12, an oxide active layer 13, a gate insulating layer 14, a gate electrode 15, an interlayer dielectric layer 16, and source and drain electrodes 17, a passivation layer 18, and a pixel electrode 19. Specifically, an insulating material or a metal oxide material is used to deposit a layer of platform film, which is being patterned through a photolithography process to form the platform layer 11.

Continuing referring to FIG. 2, a buffer layer 12 is deposited on the substrate 10 to cover the platform layer 11. Specifically, the buffer layer 12 is made of a material, such as nitride (silicon nitride, etc.) or oxide (silicon oxide, silicon dioxide), or is configured with a multilayer structure film. The buffer layer 12 formed by deposition has a convex portion 121 located corresponding to the underlying platform layer. It should be noted that in the embodiment shown in FIG. 1, the platform layer 11 is made of an insulating material, so the buffer layer 12 may not be provided. But, in order to improve adhesion between the glass substrate and functional layers on a surface of the glass substrate, and to fulfill a function of preventing impurities inside the glass substrate from diffusing into each functional layer during a process, the thin-film transistor array substrate 1 of the embodiment of the present application is provided with the buffer layer 12 disposed on another embodiment, in order to improve adhesion between the glass substrate and functional layers on a surface of the glass substrate, and to fulfill a function of preventing impurities inside the glass substrate from diffusing into each function layer during a process, the thin-film transistor array substrate 1 of the embodiment of the present application is provided with the buffer layer 12 disposed on the substrate 10 on the substrate 10

As shown in FIG. 2, an oxide active layer 13 is deposited on the buffer layer 12. The oxide active layer 13 includes a channel portion 131 and conductor portions 132 located on opposite sides of the channel portion 131. It should be noted that the channel portion 131 and the conductor portions 132 are located at different horizontal positions, that is, a vertical level of a top surface of the channel portion 131 is higher than a vertical level of a top surface of any one of the conductor portions 132. Specifically, the channel portion 131 is disposed on the convex portion 121 of the buffer layer 12 and covers the entire convex portion 121. It should be noted that the channel portion 131 includes two slopes 133, and one end of each of the slopes 133 is connected to a corresponding one of the conductor portions 132, the other end extends from the channel portion 131. Each of the slopes 133 is inclined in a direction away from the channel portion 131 and toward the corresponding conductor portion 132. As shown in FIG. 2, the buffer layer 12 is disposed between the oxide active layer 13 and the substrate 10 and the platform layer 11.

Continuing referring to FIG. 2, the gate insulating layer 14 is disposed on the oxide active layer 13. The gate electrode 15 is disposed on the gate insulating layer 14. Furthermore, after the gate insulating layer 14 undergoes the photolithography process and self-aligned etching, two offset portions 141 are formed. The two offset portions 141 are disposed at two opposite ends of the gate insulating layer 14, and each of the offset portions 141 is arranged in conformity with a corresponding one of the slopes 133 of the channel portion 131 and covers the corresponding slope 133. Specifically, each of the offset portions 141 is defined between a side edge of the gate electrode 15 and a side edge of the gate insulating layer 14 adjacent to the side edge of the gate electrode 15. It should be noted that a length of the platform layer 11 is less than a length of the channel portion 131 and is substantially the same as a length of the gate electrode 15. That is, an orthographic projection of the channel portion 131 on the substrate 10 covers an orthographic projection of the platform layer 11 on the substrate 10. In addition, an orthographic projection of the gate electrode 15 on the substrate 10 covers the orthographic projections of the platform layer 11 and the channel portion 131 on the substrate 10. In this embodiment, a length difference between the platform layer 11 and the gate electrode 15 is less than two microns. It can be seen from the schematic cross-sectional view of the thin-film transistor array substrate 1 in FIG. 2 that a first end surface 111 and a second end surface 112 of the platform layer 11 are inclined at between 40° and 80° to the horizontal, so that the first end surface 111 and the second end surface 112 each extend beyond a length range of the gate electrode 15 in vertical cross-section. In other words, an orthographic projection of each offset portion 141 on the substrate 10 falls on the first end surface 111 or the second end surface 112 of the platform layer 11.

As shown in FIG. 2, the interlayer dielectric layer 16 is deposited on the buffer layer 12 to cover the oxide active layer 13, the gate insulating layer 14, and the gate electrode 15, and the interlayer dielectric layer 16 is patterned to form a plurality of via holes 160. The source electrode and the drain electrode 17 are disposed on the interlayer dielectric layer 16 and are electrically connected to the conductor portions 132 of the oxide active layer 13 through corresponding via holes 160. In addition, a passivation layer 18 is further formed on the interlayer dielectric layer 16. In another embodiment, a planarization layer (not shown) is further provided on the passivation layer 18. A pixel electrode 19 is formed on the passivation layer 18 or on the planarization layer. The pixel electrode 19 is electrically connected to the source electrode and the drain electrode 17 through a through hole 180. Based on the aforementioned components, the embodiment of the present application provides a top gate thin-film transistor array substrate 1. Therefore, the thin-film transistor array substrate 1 of the embodiment of the application can serve as a driving substrate for subsequent liquid crystal displays or organic light-emitting diode displays.

Accordingly, in the thin-film transistor array substrate 1 of the embodiment of the present application, the platform layer 11 and adjustment of angles of the first end surface 111 and the second end surface 112 of the platform layer 11 are used to allow for formation of gentle slope-shaped offset portions 141 of upper film layer structures, such that the orthographic projections of the offset portions 141 on the substrate 10 cover the orthographic projections of the slopes 133 of the channel portion 131 on the substrate 10, respectively, and fall on the first end surface 111 and the second end surface 112 of the platform layer 11. With the provision of the offset portions 141, a conductive diffusion path of the oxide active layer 13 is extended such that lengths of low-resistance regions formed through diffusion from two ends of the channel portion 131 to an inside of the channel portion 131 are reduced after the self-aligned etching process, so as to effectively regulate or suppress shortening of an effective channel length, and ensure the effective channel length, thereby facilitating fulfillment of downsizing of TFT devices.

An embodiment of the present application further provides a method of manufacturing a thin-film transistor array substrate, that is, a method of manufacturing the thin-film transistor array substrate 1 of the above-mentioned embodiments.

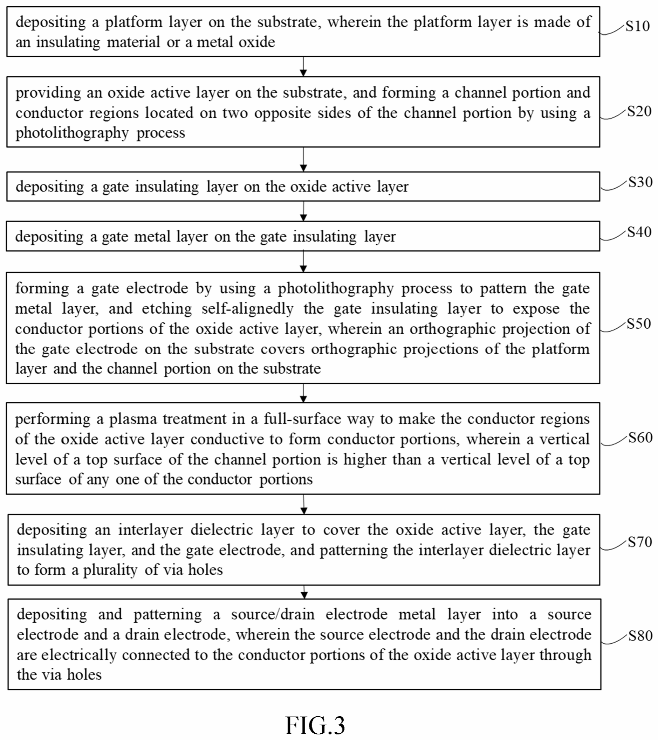

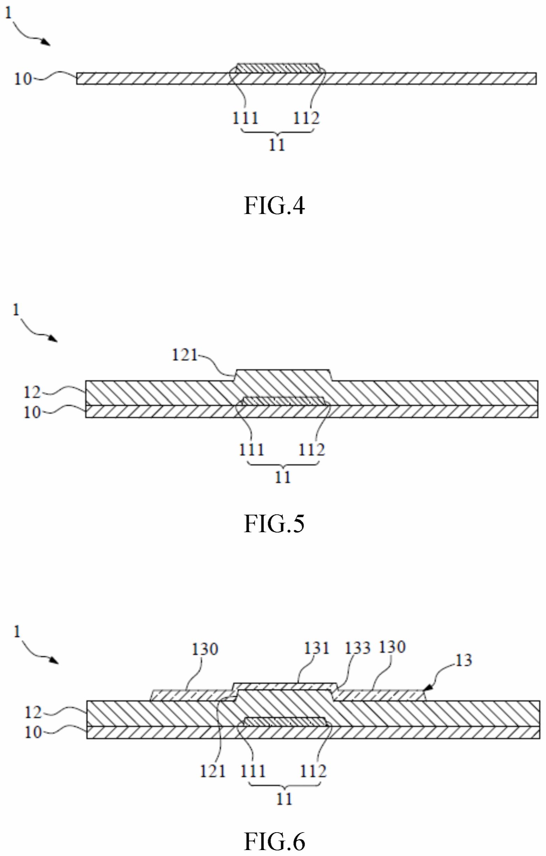

Please refer to FIGs. 3, 4, and 11. FIG. 3 is a flowchart of the method of manufacturing the thin-film transistor array substrate of the embodiment of the present application. FIGs. 4 to 11 are schematic views of film layer structures of the thin-film transistor fabricated in each step in the method of manufacturing the thin-film transistor array substrate 1 according to the embodiment of the application.

As shown in FIG. 3, the method of manufacturing the thin-film transistor array substrate 1 of the embodiment of the present application includes steps S10 to S80 as follows:
Step S10: depositing a platform layer on the substrate. Specifically, as shown in FIG. 4, the platform layer 11 on the substrate 10 has a thickness between 100 angstroms (Å) and 10000 Å and includes a first end surface 111 and a second end surface 112 tilting outward, respectively. The platform layer 11 is made of an insulating material or a metal oxide.

It should be noted that if the platform layer 11 is made of the insulating material, the thin-film transistor array substrate shown in FIG. 1 may not be provided with a buffer layer.

In another embodiment, in order to improve adhesion between the glass substrate and functional layers on a surface of the glass substrate, and to fulfill a function of preventing impurities inside the glass substrate from diffusing into each functional layer during a process. The thin-film transistor array substrate 1 of the embodiment of the present application is provided with the buffer layer 12 disposed on the substrate 10. Specifically, as shown in FIG. 5, the manufacturing method further includes step S101: depositing a buffer layer on the substrate to cover the platform layer. The buffer layer 12 is made of a material, such as silicon oxide or silicon nitride, or is configured with a multilayer structure film, and has a thickness between 1000 Å and 5000 Å, wherein the buffer layer 12 forms a convex portion 121 located directly above the platform layer 11 through a photolithography process.

Step S20: providing an oxide active layer on the substrate, and forming a channel portion and conductor regions located on two opposite sides of the channel portion by using a photolithography process. Specifically, as shown in FIG. 6, the oxide active layer 13 is made of a material of metal oxide semiconductor, such as IGZO, IZTO, or IGZTO, and has a thickness between 50Å and 1000Å. A channel portion 131 includes two slopes 133. One end of each of the slopes 133 is connected to a corresponding one of the conductor regions 130, and each of the slopes 133 is inclined in a direction away from the channel portion 131 and toward the corresponding conductor region 130. Specifically, the channel portion 131 is disposed on the convex portion 121 and covers the entire convex portion 121.

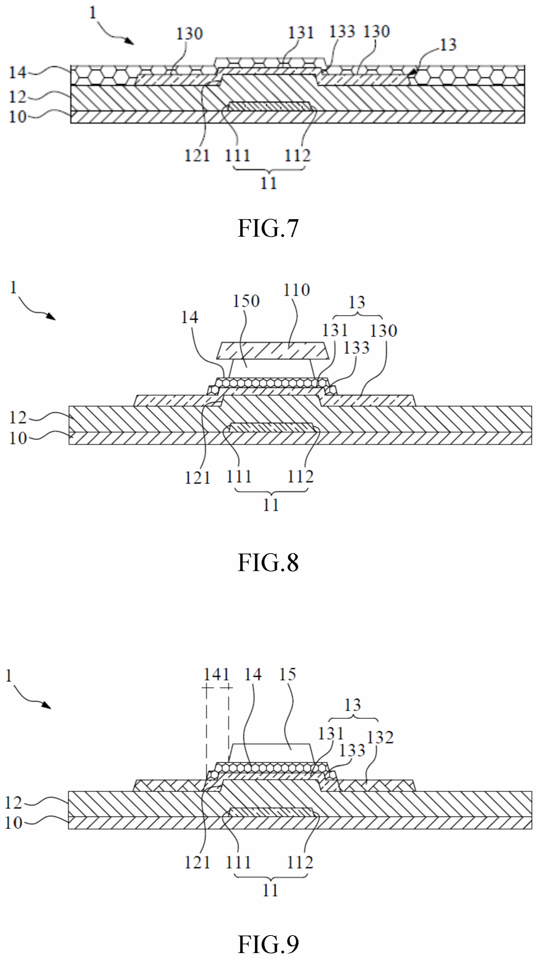

Step S30: depositing a gate insulating layer on the oxide active layer. Specifically, as shown in FIG. 7, a gate insulating layer 14 is made of a material, such as silicon oxide or silicon nitride, or is configured with a multilayer structure film, and has a thickness between 1000 Å and 3000 Å.

Step S40: depositing a gate metal layer on the gate insulating layer. Specifically, as shown in FIG. 8, a gate metal layer 150 may be made of molybdenum (Mo), aluminum (Al), copper (Cu), titanium (Ti), manganese (Mn), etc., or an alloy thereof, and has a thickness between 2000Å and 10000Å.

Step S50: forming a gate electrode by using a photolithography process to pattern the gate metal layer, and etching self-alignedly the gate insulating layer to expose the conductor portions of the oxide active layer, wherein an orthographic projection of the gate electrode on the substrate covers orthographic projections of the platform layer and the channel portion on the substrate. Specifically, as shown in FIG. 8, a photomask 110 is used to perform a photolithography process to pattern the gate metal layer 150 for formation of the gate electrode 15, and to etch self-alignedly the gate insulating layer 14 to expose the conductor regions 130 of the oxide active layer. As shown in FIG. 9, after the gate insulating layer 14 undergoes the photolithography process and self-aligned etching, two offset portions 141 are formed. The two offset portions 141 cover the slopes 133 of the channel portion131, respectively. An orthographic projection of each offset portion 141 on the substrate 10 falls on the first end surface 111 or the second end surface 112 of the platform layer 11. In addition, the orthographic projections of the offset portions 141 on the substrate 10 cover orthographic projections of the first end surface 111 and the second end surface 112 of the platform layer 11 on the substrate 10, and orthographic projections of the slopes 133 of the channel portion 133 on the substrate 10, respectively.

Step S60: performing a plasma treatment in a full-surface way to make the conductor regions of the oxide active layer conductive to form conductor portions, wherein a vertical level of a top surface of the channel portion is higher than a vertical level of a top surface of any one of the conductor portions. Specifically, as shown in FIG. 9, for the oxide active layer 13 without a photoresist/the gate insulating layer 14/the metal protection above, a resistance is significantly reduced after treatment, and N+ type conductor portions 132 are formed. Furthermore, a conductive diffusion path corresponding to the offset portions 141 on the first end surface 111 and the second end surface 112 of the terrace layer 11 is extended.

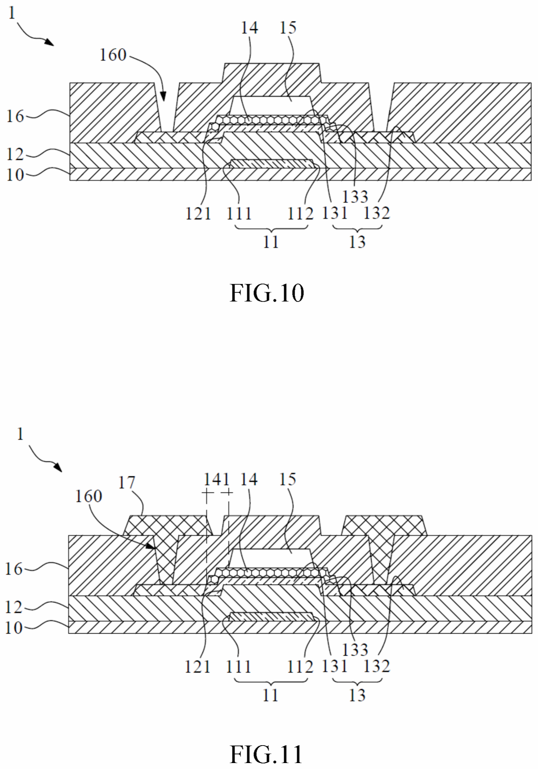

Step S70: depositing an interlayer dielectric layer to cover the oxide active layer, the gate insulating layer, and the gate electrode, and patterning the interlayer dielectric layer to form a plurality of via holes. Specifically, as shown in FIG. 10, an interlayer dielectric layer 16 is made of a material, such as silicon oxide or silicon nitride, of is configured with a multilayer structure film, and has a thickness between 1000 Å and 8000 Å. The interlayer dielectric layer 16 after being patterned exposes source/drain electrode contact regions in the oxide active layer 13 and forms a plurality of via holes 160.

Step S80: depositing and patterning a source/drain electrode metal layer into a source electrode and a drain electrode, wherein the source electrode and the drain electrode are electrically connected to the conductor portions of the oxide active layer through the via holes. Specifically, as shown in FIG. 11, a source/drain metal layer is deposited on the interlayer dielectric layer 16, wherein the source/drain metal layer can be made of Mo, Al, Cu, Ti, Mn, etc., or its alloys, and has a thickness between 2000Å and 10000Å . Source and drain electrodes 17 are formed by patterning the source/drain electrode metal layer and are electrically connected to the conductor portions 132 of the oxide active layer 13 through the via holes 160.

In addition, as shown in FIGs. 1 and 2, a passivation layer 18 is further formed on the interlayer dielectric layer 16 and is made of a material, such as silicon nitride or silicon oxide, or is configured with a multilayer structure film. The passivation layer 18 has a thickness between 1000 Å and 5000 Å and forms a through hole 180 through a photolithography process. In another embodiment, a planarization layer (not shown) is further provided on the passivation layer 18. Finally, a pixel electrode layer is fabricated under the above-mentioned basic film structure, and the pixel electrode layer is patterned to form a pixel electrode 19, which is electrically connected to the source electrode and the drain electrode 17 through the through hole 180. Therefore, the thin-film transistor array substrate 1 of the embodiment of the application can serve as a driving substrate for subsequent liquid crystal displays or organic light-emitting diode displays.

Accordingly, in a thin-film transistor array substrate and a method of manufacturing the same of the embodiments of the present application, a platform layer and adjustment of angles of a first end surface and a second end surface of the platform layer are used to allow for formation of gentle slope-shaped offset portions of upper film layer structures, such that orthographic projections of the offset portions on a substrate cover orthographic projections of slopes of a channel portion on the substrate, and fall on a first end surface and a second end surface of the platform layer, respectively. With the provision of the offset portions, a conductive diffusion path of the oxide active layer is extended such that lengths of low-resistance regions formed through diffusion from two ends of the channel portion to an inside of the channel portion are reduced after the self-aligned etching process, so as to effectively regulate or suppress shortening of an effective channel length, and ensure the effective channel length, thereby facilitating fulfillment of downsizing of TFT devices and effectively overcoming a technical problem that diffusion of electrically conductive effects on both ends of a channel of a conventional thin-film transistor device will lead to low-resistance regions at the both ends of the channel, resulting in a decrease in an effective channel length, which is not conducive to downsizing of thin-film transistor devices.

In the above-mentioned embodiments, the description of each embodiment has its own emphasis. For parts that are not described in detail in an embodiment, reference may be made to related descriptions of other embodiments.

## Claims

1. A thin-film transistor array substrate (1), comprising:
a substrate (10);
a platform layer (11) disposed on the substrate (10);
an oxide active layer (13) disposed on the substrate (10) and located above the platform layer (11) and comprising a channel portion (131) and conductor portions (132) located on opposite sides of the channel portion (131), wherein a vertical level of a top surface of the channel portion (131) is higher than a vertical level of a top surface of any one of the conductor portions (132);
a gate insulating layer (14) disposed on the oxide active layer (13);
a gate electrode (15) disposed on the gate insulating layer (14), wherein an orthographic projection of the gate electrode (15) on the substrate (10) overlaps orthographic projections of the platform layer (11) and the channel portion (131) on the substrate (10); and
a source electrode and a drain electrode (17) both electrically connected to the conductor portions (132);
**characterized in that** the channel portion (131) comprises two slopes (133), and one end of each of the slopes (133) is connected to a corresponding one of the conductor portions (132), wherein each of the slopes (133) is inclined in a direction away from the channel portion (131) and toward the corresponding conductor portion (132);
the channel portion (131) comprises a first planar portion (1311) and a second planar portion (1313), the second planar portion (1313) connected between the first planar portion (1311) and the conductor portion (132), wherein a vertical level of a top surface of the first planar portion (1311) is higher than a vertical level of a top surface of the second planar portion (1313), and the vertical level of the top surface of the second planar portion (1313) is equal to the vertical level of the top surface of the conductor portion (132);
the gate electrode (15) is planar, and a projection of the gate electrode (15) on the first planar portion (1311) is located within a boundary of the first planar portion (1311); the platform layer (11) comprises a first end surface (111) and a second end surface (112) inclined outward, respectively, and the first end surface (111) and the second end surface (112) are inclined at an angle of 40°-80° with respect to the substrate, such that the first end surface (111) and the second end surface (112) each extend beyond a length range of the gate electrode (15) in a vertical cross-section;
the gate insulating layer (14) comprises two offset portions (141) disposed opposite to each other, wherein each of the offset portions (141) is defined between a side edge of the gate electrode (15) and an adjacent side edge of the gate insulating layer (14), such that orthographic projections of the two offset portions (141) on the substrate (10) respectively cover orthographic projections of the first end surface (111) and the second end surface (112) of the platform layer (11) and orthographic projections of the slopes (133) of the channel portion (131) on the substrate (10).

2. The thin-film transistor array substrate (1) according to claim 1, further comprising a buffer layer (12) disposed on the substrate (10) and covers the platform layer (11), wherein the platform layer (11) is made of an insulating material or a metal oxide.

3. The thin-film transistor array substrate (1) according to claim 2, **characterized in that** the buffer layer (12) comprises a convex portion (121), and the channel portion (131) is disposed on the convex portion (121) and covers the entire convex portion (121).

4. The thin-film transistor array substrate according to any one of claims 1 to 3, further comprising an interlayer dielectric layer (16) covering the oxide active layer (13), the gate insulating layer (14), and the gate electrode (15), and comprising a plurality of via holes (160), wherein the source electrode and the drain electrode (17) are arranged on the interlayer dielectric layer (16) and are electrically connected to the conductor portions (132) through the via holes (160).

5. A method of manufacturing a thin-film transistor array substrate (1), comprising:
depositing a platform layer (11) on a substrate (10), wherein the platform layer (11) is made of an insulating material or a metal oxide;
forming an oxide active layer (13) on the substrate (10), and forming a channel portion (131) and conductor regions (130) located on two opposite sides of the channel portion (131) by using a photolithography process;
depositing a gate insulating layer (14) on the oxide active layer (13);
depositing a gate metal layer (150) on the gate insulating layer (14);
forming, by using a photolithography process to pattern the gate metal layer (150), a gate electrode (15), and etching self-alignedly the gate insulating layer (14) to expose the conductor portions (132) of the oxide active layer (13), wherein an orthographic projection of the gate electrode (15) on the substrate (10) overlaps orthographic projections of the platform layer (11) and the channel portion (131) on the substrate (10);
performing a plasma treatment in a full-surface way to make the conductor regions (130) of the oxide active layer (13) conductive to form conductor portions (132), wherein a vertical level of a top surface of the channel portion (131) is higher than a vertical level of a top surface of any one of the conductor portions (132);
depositing an interlayer dielectric layer (16) to cover the oxide active layer (13), the gate insulating layer (14), and the gate electrode (15), and patterning the interlayer dielectric layer (16) to form a plurality of via holes (160); and
depositing and patterning a source electrode/drain electrode metal layer into a source electrode and a drain electrode (17), wherein the source electrode and the drain electrode (17) are electrically connected to the conductor portions (132) of the oxide active layer (13) through the via holes (160);
wherein the channel portion (131) comprises two slopes (133), and one end of each of the slopes (133) is connected to a corresponding one of the conductor portions (132), wherein each of the slopes (133) is inclined in a direction away from the channel portion (131) and toward the corresponding conductor portion (132);
the channel portion (131) comprises a first planar portion (1311) and a second planar portion (1313), the second planar portion (1313) connected between the first planar portion (1311) and the conductor portion (132), wherein a vertical level of a top surface of the first planar portion (1311) is higher than a vertical level of a top surface of the second planar portion (1313), and the vertical level of the top surface of the second planar portion (1313) is equal to the vertical level of the top surface of the conductor portion (132);
the gate electrode (15) is planar, and a projection of the gate electrode (15) on the first planar portion (1311) is located within a boundary of the first planar portion (1311); the platform layer (11) comprises a first end surface (111) and a second end surface (112) inclined outward, respectively, and the first end surface (111) and the second end surface (112) are inclined at an angle of 40°-80° with respect to the substrate, such that the first end surface (111) and the second end surface (112) each extend beyond a length range of the gate electrode (15) in a vertical cross-section;
the gate insulating layer (14) comprises two offset portions (141) disposed opposite to each other, wherein each of the offset portions (141) is defined between a side edge of the gate electrode (15) and an adjacent side edge of the gate insulating layer (14), such that orthographic projections of the two offset portions (141) on the substrate (10) respectively cover orthographic projections of the first end surface (111) and the second end surface (112) of the platform layer (11) and orthographic projections of the slopes (133) of the channel portion (131) on the substrate (10).

6. The method of manufacturing the thin-film transistor array substrate (1) according to claim 5, **characterized in that** prior to the step of forming the oxide active layer (13) on the substrate (10), the method further comprises: depositing a buffer layer (12) on the substrate (10) to cover the platform layer (11), and the buffer layer (12) is formed by a photolithography process to form a convex portion (121) located directly above the platform layer (11), wherein the channel portion (131) is disposed on the convex portion (121) and covers the entire convex portion (121).

7. The method of manufacturing the thin-film transistor array substrate (1) according to claim 6, **characterized in that** the channel portion (131) comprises two slopes (133), one end of each of the slopes (133) is connected to a corresponding one of the conductor portions (132), and each of the slopes (133) is inclined in a direction away from the channel portion (131) and toward the corresponding conductor portion (132), wherein the gate insulating layer (14) comprises two offset portions (141) disposed opposite to each other, wherein each of the offset portions (141) is formed between a side edge of the gate electrode (15) and a side edge of the gate insulating layer (14) adjacent to the side edge of the gate electrode (15) such that orthographic projections of the two offset portions (141) on the substrate (10) cover orthographic projections of the first end surface (111) and the second end surface (112) of the platform layer (11) and orthographic projections of the slopes (133) of the channel portion (131) on the substrate (10), respectively.

## Patentansprüche

1. Ein Substrat (1) für eine Dünnschichttransistoranordnung, umfassend:
ein Substrat (10);
eine auf dem Substrat (10) angeordnete Plattformschicht (11);
eine auf dem Substrat (10) angeordnete und über der Plattformschicht (11) liegende aktive Oxidschicht (13), die einen Kanalabschnitt (131) und auf gegenüberliegenden Seiten des Kanalabschnitts (131) angeordnete Leiterabschnitte (132) umfasst, wobei eine vertikale Höhe einer Oberseite des Kanalabschnitts (131) höher ist als eine vertikale Höhe einer Oberseite eines beliebigen der Leiterabschnitte (132);
eine Gate-Isolierschicht (14), die auf der aktiven Oxidschicht (13) angeordnet ist;
eine Gate-Elektrode (15), die auf der Gate-Isolierschicht (14) angeordnet ist, wobei eine orthogonale Projektion der Gate-Elektrode (15) auf das Substrat (10) die orthogonalen Projektionen der Plattformschicht (11) und des Kanalabschnitts (131) auf das Substrat (10) überlappt; und
eine Source-Elektrode und eine Drain-Elektrode (17), die beide elektrisch mit den Leiterabschnitten (132) verbunden sind;
**dadurch gekennzeichnet, dass** der Kanalabschnitt (131) zwei Schrägen (133) umfasst und ein Ende jeder der Schrägen (133) mit einem entsprechenden der Leiterabschnitte (132) verbunden ist, wobei jede der Schrägen (133) in einer Richtung weg vom Kanalabschnitt (131) und hin zum entsprechenden Leiterabschnitt (132) geneigt ist;
der Kanalabschnitt (131) einen ersten ebenen Abschnitt (1311) und einen zweiten ebenen Abschnitt (1313) umfasst, wobei der zweite ebene Abschnitt (1313) zwischen dem ersten ebenen Abschnitt (1311) und dem Leiterabschnitt (132) angeschlossen ist, wobei eine vertikale Höhe einer Oberseite des ersten ebenen Abschnitts (1311) höher ist als eine vertikale Höhe einer Oberseite des zweiten ebenen Abschnitts (1313), und die vertikale Höhe der Oberseite des zweiten ebenen Abschnitts (1313) gleich der vertikalen Höhe der Oberseite des Leiterabschnitts (132) ist;
die Gate-Elektrode (15) planar ist und eine Projektion der Gate-Elektrode (15) auf den ersten ebenen Abschnitt (1311) innerhalb einer Begrenzung des ersten ebenen Abschnitts (1311) liegt; die Plattformschicht (11) eine erste Endfläche (111) und eine zweite Endfläche (112) aufweist, die jeweils nach außen geneigt sind, und die erste Endfläche (111) und die zweite Endfläche (112) in einem Winkel von 40° bis 80° zum Substrat geneigt sind, so dass die erste Endfläche (111) und die zweite Endfläche (112) jeweils über einen Längenbereich der Gate-Elektrode (15) in einem vertikalen Querschnitt hinausragen;
die Gate-Isolierschicht (14) zwei einander gegenüberliegende Versatzabschnitte (141) umfasst, wobei jeder der Versatzabschnitte (141) zwischen einer Seitenkante der Gate-Elektrode (15) und einer benachbarten Seitenkante der Gate-Isolierschicht (14) definiert ist, so dass orthogonale Projektionen der beiden Versatzabschnitte (141) auf das Substrat (10) jeweils orthogonale Projektionen der ersten Endfläche (111) und der zweiten Endfläche (112) der Plattformschicht (11) sowie orthogonale Projektionen der Schrägen (133) des Kanalabschnitts (131) auf das Substrat (10) überdecken.

2. Das Dünnschichttransistor-Array-Substrat (1) nach Anspruch 1, das ferner eine Pufferschicht (12) umfasst, die auf dem Substrat (10) angeordnet ist und die Plattformschicht (11) bedeckt, wobei die Plattformschicht (11) aus einem isolierenden Material oder einem Metalloxid besteht.

3. Dünnschichttransistor-Array-Substrat (1) nach Anspruch 2, **dadurch gekennzeichnet, dass** die Pufferschicht (12) einen konvexen Abschnitt (121) umfasst und der Kanalabschnitt (131) auf dem konvexen Abschnitt (121) angeordnet ist und den gesamten konvexen Abschnitt (121) bedeckt.

4. Dünnschichttransistor-Array-Substrat nach einem der Ansprüche 1 bis 3, das ferner eine die aktive Oxidschicht (13) bedeckende Zwischenschicht-Dielektrikumsschicht (16), die Gate-Isolierschicht (14) und die Gate-Elektrode (15) bedeckt und eine Vielzahl von Durchkontaktierungslöchern (160) umfasst, wobei die Source-Elektrode und die Drain-Elektrode (17) auf der Zwischenschicht-Dielektrikumsschicht (16) angeordnet sind und über die Durchkontaktierungslöcher (160) elektrisch mit den Leiterabschnitten (132) verbunden sind.

5. Verfahren zur Herstellung eines Dünnschichttransistor-Array-Substrats (1), umfassend:
Aufbringen einer Plattformschicht (11) auf ein Substrat (10), wobei die Plattformschicht (11) aus einem isolierenden Material oder einem Metalloxid besteht;
Bilden einer aktiven Oxidschicht (13) auf dem Substrat (10) und Bilden eines Kanalabschnitts (131) und von Leiterbereichen (130), die sich auf zwei gegenüberliegenden Seiten des Kanalabschnitts (131) befinden, unter Verwendung eines Photolithografieverfahrens;
Aufbringen einer Gate-Isolierschicht (14) auf die aktive Oxidschicht (13);
Aufbringen einer Gate-Metallschicht (150) auf die Gate-Isolierschicht (14);
Bilden einer Gate-Elektrode (15) unter Verwendung eines Photolithografieverfahrens zum Strukturieren der Gate-Metallschicht (150), und selbstausrichtendes Ätzen der Gate-Isolierschicht (14), um die Leiterabschnitte (132) der aktiven Oxidschicht (13) freizulegen, wobei eine orthogonale Projektion der Gate-Elektrode (15) auf das Substrat (10) die orthogonalen Projektionen der Plattformschicht (11) und des Kanalabschnitts (131) auf das Substrat (10) überlappt;
Durchführen einer Plasma-Behandlung über die gesamte Oberfläche, um die Leiterbereiche (130) der aktiven Oxidschicht (13) leitfähig zu machen und Leiterabschnitte (132) zu bilden, wobei eine vertikale Höhe einer Oberseite des Kanalabschnitts (131) höher ist als eine vertikale Höhe einer Oberseite eines beliebigen der Leiterabschnitte (132);
Abscheiden einer Zwischenschicht-Dielektrikumsschicht (16), um die aktive Oxidschicht (13), die Gate-Isolierschicht (14) und die Gate-Elektrode (15) zu bedecken, und Strukturieren der Zwischenschicht-Dielektrikumsschicht (16), um eine Vielzahl von Durchkontaktierungslöchern (160) zu bilden; und
Aufbringen und Strukturieren einer Source-Elektroden-/Drain-Elektroden-Metallschicht zu einer Source-Elektrode und einer Drain-Elektrode (17), wobei die Source-Elektrode und die Drain-Elektrode (17) über die Durchkontaktierungslöcher (160) elektrisch mit den Leiterabschnitten (132) der aktiven Oxidschicht (13) verbunden sind;
wobei der Kanalabschnitt (131) zwei Schrägen (133) umfasst und ein Ende jeder der Schrägen (133) mit einem entsprechenden der Leiterabschnitte (132) verbunden ist, wobei jede der Schrägen (133) in einer Richtung weg vom Kanalabschnitt (131) und hin zum entsprechenden Leiterabschnitt (132) geneigt ist;
der Kanalabschnitt (131) einen ersten ebenen Abschnitt (1311) und einen zweiten ebenen Abschnitt (1313) umfasst, wobei der zweite ebene Abschnitt (1313) zwischen dem ersten ebenen Abschnitt (1311) und dem Leiterabschnitt (132) verbunden ist, wobei eine vertikale Höhe einer Oberseite des ersten ebenen Abschnitts (1311) höher ist als eine vertikale Höhe einer Oberseite des zweiten ebenen Abschnitts (1313), und die vertikale Höhe der Oberseite des zweiten ebenen Abschnitts (1313) gleich der vertikalen Höhe der Oberseite des Leiterabschnitts (132) ist;
die Gate-Elektrode (15) planar ist und eine Projektion der Gate-Elektrode (15) auf den ersten ebenen Abschnitt (1311) innerhalb einer Begrenzung des ersten ebenen Abschnitts (1311) liegt; die Plattformschicht (11) eine erste Endfläche (111) und eine zweite Endfläche (112) aufweist, die jeweils nach außen geneigt sind, und die erste Endfläche (111) und die zweite Endfläche (112) in einem Winkel von 40° bis 80° zum Substrat geneigt sind, so dass die erste Endfläche (111) und die zweite Endfläche (112) jeweils über einen Längenbereich der Gate-Elektrode (15) in einem vertikalen Querschnitt hinausragen;
die Gate-Isolierschicht (14) zwei Versatzabschnitte (141) umfasst, die einander gegenüberliegend angeordnet sind, wobei jeder der Versatzabschnitte (141) zwischen einer Seitenkante der Gate-Elektrode (15) und einer benachbarten Seitenkante der Gate-Isolierschicht (14) definiert ist, so dass orthogonale Projektionen der beiden Versatzabschnitte (141) auf das Substrat (10) jeweils orthogonale Projektionen der ersten Endfläche (111) und der zweiten Endfläche (112) der Plattformschicht (11) sowie orthogonale Projektionen der Schrägen (133) des Kanalabschnitts (131) auf das Substrat (10) überdecken.

6. Verfahren zur Herstellung des Dünnschichttransistor-Array-Substrats (1) nach Anspruch 5, **dadurch gekennzeichnet, dass** das Verfahren vor dem Schritt des Bildens der aktiven Oxidschicht (13) auf dem Substrat (10) ferner umfasst: Aufbringen einer Pufferschicht (12) auf das Substrat (10), um die Plattformschicht (11) zu bedecken, und die Pufferschicht (12) durch ein photolithografisches Verfahren gebildet wird, um einen konvexen Abschnitt (121) zu bilden, der sich direkt über der Plattformschicht (11) befindet, wobei der Kanalabschnitt (131) auf dem konvexen Abschnitt (121) angeordnet ist und den gesamten konvexen Abschnitt (121) bedeckt.

7. Verfahren zur Herstellung des Dünnschichttransistor-Array-Substrats (1) nach Anspruch 6, **dadurch gekennzeichnet, dass** der Kanalabschnitt (131) zwei Schrägen (133) umfasst, wobei ein Ende jeder der Schrägen (133) mit einem entsprechenden der Leiterabschnitte (132) verbunden ist und jede der Schrägen (133) in einer Richtung weg vom Kanalabschnitt (131) und in Richtung des entsprechenden Leiterabschnitts (132) geneigt ist, wobei die Gate-Isolierschicht (14) zwei einander gegenüberliegende Versatzabschnitte (141) umfasst, wobei jeder der Versatzabschnitte (141) zwischen einer Seitenkante der Gate-Elektrode (15) und einer Seitenkante der Gate-Isolierschicht (14) benachbart zur Seitenkante der Gate-Elektrode (15) angeordnet ist, derart, dass orthogonale Projektionen der beiden Versatzabschnitte (141) auf das Substrat (10) orthogonale Projektionen der ersten Endfläche (111) und der zweiten Endfläche (112) der Plattformschicht (11) bzw. orthogonale Projektionen der Schrägen (133) des Kanalabschnitts (131) auf das Substrat (10) überdecken.

## Revendications

1. Un substrat (1) pour réseau de transistors à couche mince, comprenant :
un substrat (10) ;
une couche de plate-forme (11) disposée sur le substrat (10) ;
une couche active d'oxyde (13) disposée sur le substrat (10) et située au-dessus de la couche de plate-forme (11) et comprenant une partie de canal (131) et des parties conductrices (132) situées sur les côtés opposés de la partie de canal (131), dans lequel un niveau vertical d'une surface supérieure de la partie de canal (131) est plus élevé qu'un niveau vertical d'une surface supérieure de l'une quelconque des parties conductrices (132) ;
une couche isolante de grille (14) disposée sur la couche active d'oxyde (13) ;
une électrode de grille (15) disposée sur la couche isolante de grille (14), dans laquelle une projection orthogonale de l'électrode de grille (15) sur le substrat (10) recouvre les projections orthogonales de la couche de plate-forme (11) et de la partie de canal (131) sur le substrat (10) ; et
une électrode de source et une électrode de drain (17) toutes deux connectées électriquement aux parties conductrices (132) ;
**caractérisé en ce que** la partie de canal (131) comprend deux pentes (133), et une extrémité de chacune des pentes (133) est connectée à l'une correspondante des parties conductrices (132), dans lequel chacune des pentes (133) est inclinée dans une direction s'éloignant de la partie de canal (131) et vers la partie conductrice correspondante (132) ;
la partie de canal (131) comprend une première partie plane (1311) et une deuxième partie plane (1313), la deuxième partie plane (1313) étant reliée entre la première partie plane (1311) et la partie conductrice (132), dans laquelle le niveau vertical d'une surface supérieure de la première partie plane (1311) est plus élevé que le niveau vertical d'une surface supérieure de la deuxième partie plane (1313), et le niveau vertical de la surface supérieure de la deuxième partie plane (1313) est égal au niveau vertical de la surface supérieure de la partie conductrice (132) ;
l'électrode de grille (15) est plane, et une projection de l'électrode de grille (15) sur la première partie plane (1311) est située à l'intérieur d'une limite de la première partie plane (1311) ; la couche de plate-forme (11) comprend une première surface d'extrémité (111) et une deuxième surface d'extrémité (112) inclinées vers l'extérieur, respectivement, et la première surface d'extrémité (111) et la deuxième surface d'extrémité (112) sont inclinées selon un angle de 40° à 80° par rapport au substrat, de telle sorte que la première surface d'extrémité (111) et la deuxième surface d'extrémité (112) s'étendent chacune au-delà d'une plage de longueur de l'électrode de grille (15) dans une section transversale verticale ;
la couche isolante de grille (14) comprend deux parties décalées (141) disposées en vis-à-vis l'une de l'autre, chacune des parties décalées (141) étant définie entre un bord latéral de l'électrode de grille (15) et un bord latéral adjacent de la couche isolante de grille (14), de telle sorte que les projections orthogonales des deux parties décalées (141) sur le substrat (10) recouvrent respectivement les projections orthogonales de la première surface d'extrémité (111) et de la deuxième surface d'extrémité (112) de la couche de plate-forme (11) et les projections orthogonales des pentes (133) de la partie de canal (131) sur le substrat (10).

2. Substrat de réseau de transistors à couche mince (1) selon la revendication 1, comprenant en outre une couche tampon (12) disposée sur le substrat (10) et recouvrant la couche de plate-forme (11), dans lequel la couche de plate-forme (11) est constituée d'un matériau isolant ou d'un oxyde métallique.

3. Substrat de réseau de transistors à couche mince (1) selon la revendication 2, **caractérisé en ce que** la couche tampon (12) comprend une partie convexe (121), et la partie de canal (131) est disposée sur la partie convexe (121) et recouvre l'ensemble de la partie convexe (121).

4. Substrat de réseau de transistors à couche mince selon l'une quelconque des revendications 1 à 3, comprenant en outre une couche diélectrique intercouche (16) recouvrant la couche active d'oxyde (13), la couche isolante de grille (14) et l'électrode de grille (15), et comprenant une pluralité de trous de passage (160), dans lequel l'électrode de source et l'électrode de drain (17) sont disposées sur la couche diélectrique intercouche (16) et sont connectées électriquement aux parties conductrices (132) par l'intermédiaire des trous de passage (160).

5. Procédé de fabrication d'un substrat de réseau de transistors à couche mince (1), comprenant :
le dépôt d'une couche de plate-forme (11) sur un substrat (10), dans lequel la couche de plate-forme (11) est constituée d'un matériau isolant ou d'un oxyde métallique ;
la formation d'une couche active d'oxyde (13) sur le substrat (10), et la formation d'une partie de canal (131) et de régions conductrices (130) situées sur deux côtés opposés de la partie de canal (131) à l'aide d'un procédé de photolithographie ;
le dépôt d'une couche isolante de grille (14) sur la couche active d'oxyde (13) ;
déposer une couche métallique de grille (150) sur la couche isolante de grille (14) ;
former, à l'aide d'un procédé de photolithographie pour structurer la couche métallique de grille (150), une électrode de grille (15), et graver de manière auto-alignée la couche isolante de grille (14) pour exposer les parties conductrices (132) de la couche active d'oxyde (13), dans lequel une projection orthogonale de l'électrode de grille (15) sur le substrat (10) recouvre les projections orthogonales de la couche de plate-forme (11) et de la partie de canal (131) sur le substrat (10) ;
réaliser un traitement au plasma sur toute la surface afin de rendre conductrices les régions conductrices (130) de la couche active d'oxyde (13) pour former des parties conductrices (132), dans lequel le niveau vertical d'une surface supérieure de la partie de canal (131) est plus élevé que le niveau vertical d'une surface supérieure de l'une quelconque des parties conductrices (132) ;
déposer une couche diélectrique intercouche (16) pour recouvrir la couche active d'oxyde (13), la couche isolante de grille (14) et l'électrode de grille (15), et structurer la couche diélectrique intercouche (16) pour former une pluralité de trous de passage (160) ; et
déposer et structurer une couche métallique d'électrode de source/électrode de drain pour former une électrode de source et une électrode de drain (17), dans lesquelles l'électrode de source et l'électrode de drain (17) sont connectées électriquement aux parties conductrices (132) de la couche active d'oxyde (13) par l'intermédiaire des trous de passage (160) ;
dans lequel la partie de canal (131) comprend deux pentes (133), et une extrémité de chacune des pentes (133) est connectée à l'une correspondante des parties conductrices (132), chacune des pentes (133) étant inclinée dans une direction s'éloignant de la partie de canal (131) et se dirigeant vers la partie conductrice correspondante (132) ;
la partie de canal (131) comprend une première partie plane (1311) et une deuxième partie plane (1313), la deuxième partie plane (1313) étant reliée entre la première partie plane (1311) et la partie conductrice (132), dans laquelle un niveau vertical d'une surface supérieure de la première partie plane (1311) est plus élevé que le niveau vertical d'une surface supérieure de la deuxième partie plane (1313), et le niveau vertical de la surface supérieure de la deuxième partie plane (1313) est égal au niveau vertical de la surface supérieure de la partie conductrice (132) ;
l'électrode de grille (15) est plane, et une projection de l'électrode de grille (15) sur la première partie plane (1311) est située à l'intérieur d'une limite de la première partie plane (1311) ; la couche de plate-forme (11) comprend une première surface d'extrémité (111) et une deuxième surface d'extrémité (112) inclinées vers l'extérieur, respectivement, et la première surface d'extrémité (111) et la deuxième surface d'extrémité (112) sont inclinées selon un angle de 40° à 80° par rapport au substrat, de telle sorte que la première surface d'extrémité (111) et la deuxième surface d'extrémité (112) s'étendent chacune au-delà d'une plage de longueur de l'électrode de grille (15) dans une section transversale verticale ;
la couche isolante de grille (14) comprend deux parties décalées (141) disposées en vis-à-vis l'une de l'autre, chacune des parties décalées (141) étant définie entre un bord latéral de l'électrode de grille (15) et un bord latéral adjacent de la couche isolante de grille (14), de telle sorte que les projections orthogonales des deux parties décalées (141) sur le substrat (10) recouvrent respectivement les projections orthogonales de la première surface d'extrémité (111) et de la deuxième surface d'extrémité (112) de la couche de plate-forme (11) et les projections orthogonales des pentes (133) de la partie de canal (131) sur le substrat (10).

6. Procédé de fabrication du substrat de réseau de transistors à couche mince (1) selon la revendication 5, **caractérisé en ce que**, avant l'étape de formation de la couche active d'oxyde (13) sur le substrat (10), le procédé comprend en outre : le dépôt d'une couche tampon (12) sur le substrat (10) pour recouvrir la couche de plate-forme (11), et la couche tampon (12) est formée par un procédé de photolithographie afin de former une partie convexe (121) située directement au-dessus de la couche de plate-forme (11), dans lequel la partie de canal (131) est disposée sur la partie convexe (121) et recouvre l'intégralité de la partie convexe (121).

7. Procédé de fabrication du substrat de réseau de transistors à couche mince (1) selon la revendication 6, **caractérisé en ce que** la partie de canal (131) comprend deux pentes (133), une extrémité de chacune des pentes (133) est reliée à l'une correspondante des parties conductrices (132), et chacune des pentes (133) est inclinée dans une direction s'éloignant de la partie de canal (131) et vers la partie conductrice correspondante (132), dans lequel la couche isolante de grille (14) comprend deux parties décalées (141) disposées en vis-à-vis l'une de l'autre, dans lequel chacune des parties décalées (141) est formée entre un bord latéral de l'électrode de grille (15) et un bord latéral de la couche isolante de grille (14) adjacent au bord latéral de l'électrode de grille (15) de telle sorte que les projections orthogonales des deux parties décalées (141) sur le substrat (10) recouvrent respectivement les projections orthogonales de la première surface d'extrémité (111) et de la deuxième surface d'extrémité (112) de la couche de plate-forme (11) et les projections orthogonales des pentes (133) de la partie de canal (131) sur le substrat (10).
